# EUROPÄISCHE PATENTSCHRIFT

(11) **EP 0 684 456 B1**
(45) Veröffentlichungstag und Bekanntmachung des Hinweises auf die Patenterteilung: **07.03.2001**
(21) Anmeldenummer: 95250087.4
(22) Anmeldetag: 07.04.1995
(51) Int. Cl.: G01D 9/28, G01D 9/08, G01R 13/08

(54) **Linienschreiber**
Line recorder
Appareil d'enregistrement graphique

(30) Priorität: 24.05.1994 DE 4418787
(43) Veröffentlichungstag der Anmeldung: 29.11.1995
(73) Patentinhaber: ABB PATENT GmbH, 68309 Mannheim (DE)
(72) Erfinder: Kirste, Hans-Herbert, D-31628 Landesbergen (DE)
(74) Vertreter: Presting, Hans-Joachim, Dipl.-Ing.

(56) Entgegenhaltungen:
- EP-A- 0 010 622
- GB-A- 2 072 339
- US-A- 4 258 369

## Beschreibung

Die Erfindung betrifft einen Linienschreiber mit einer vorgegebenen Anzahl kontinuierlicher Schreibsysteme zur Aufzeichnung geschlossener Linienzüge und einem diskontinuierlichen Schreibsystem zur Aufzeichnung alphanumerischer Zeichen auf einen Aufzeichnungsträger zur Visualisierung von Prozeßgrößen.

Es ist ein Linienschreiber, Hartmann & Braun Listenblatt 10/42-4.10, bekannt, der alternativ n kontinuierliche Schreibsysteme für n Meßkanäle in Kombination mit einem nach dem seriellen Punktmatrix-Verfahren arbeitenden direkt schreibenden Drucksystem oder n+1 kontinuierliche Schreibsystem für n+1 Meßkanäle aufweist. Die Schreibsysteme und das Drucksystem sind jeweils in mechanisch gleichartigen Modulen realisiert, die in Schächten des Linienschreibers austauschbar untergebracht sind. Zur Darstellung der alternativen Varianten wird ein Schreibsystem durch das Drucksystem ersetzt bzw. umgekehrt. Jedem Schreibsystem sind Mittel zur Meßwertbearbeitung zugeordnet. Dem Drucksystem ist ein Zeichengenerator zugeordnet.

Aus der US 4,258,369 ist ein Aufzeichnungsgerät vom Typ Linienschreiber mit einem kontinuierlichen Schreibsystem zur Aufzeichnung von Analogsignalen kontinuierlicher Wellenform bekannt, dessen Aufzeichnungsorgan in stetigem Kontakt mit dem Aufzeichnungsträger steht. Dieses Aufzeichnungsgerät ist mit einem digitalen Zeichengenerator und einem diesem nachgeschalteten Digital-Analog-Wander ausgestattet. Darüber hinaus ist ein Umschalter vorgesehen, der in Abhängigkeit von einem wählbaren Betriebsmodus die Aufzeichnung von kontinuierlichen Analogsignalen oder von alphanumerischer Zeichen gestattet. Dabei ist die Aufzeichnung von alphanumerischen Zeichen am Beginn, am Ende oder während der Aufzeichnung von analogen Meßwerten vorgesehen.

Infolge des in stetigem Kontakt mit dem Aufzeichnungsträger stehenden Aufzeichnungsorgans sind die Rasterpunkte der analoggewandelten alphanumerischen Zeichen miteinander durch aufgezeichnete Linien verbunden, die die Lesbarkeit der alphanumerischen Zeichen erschweren. Darüber hinaus ist die Aufzeichnung auf eine Kette alphanumerischer Zeichen entlang der Vorschubrichtung des Aufzeichnungsträgers beschränkt, wobei während der Auzeichnung eines Zeichens oder einer Zeichenkette die Aufzeichnung von analogen Meßwerten verhindert ist.

Darüber hinaus ist aus der GB 2 072 339 ein Schreiber zur diskontinuierlichen und wechselweisen Aufzeichnung von Meßwerten und alphanumerischen Daten mit demselben Schreibsystem bekannt. Dabei ist für die Dauer der gesamten Aufzeichnung alphanumerischer Daten die Aufzeichnung von Meßwerten unterbrochen. Insbesondere bei volatilen Meßwerten sind diese Unterbrechungen durch den damit einhergehenden Informationsverlust nachteilig.

Der Erfindung liegt die Rufgabe zugrunde, einen Linienschreiber der gattungsgemäßen Art derart weiterzuentwickeln, daß unter Verzicht auf zusätzliche mechanische Komponenten sowohl die Meßwerte von n+1 Meßkanälen als auch alphanumerische Zeichen aufzeichenbar sind.

Erfindungsgemäß wird diese Aufgabe mit den Merkmalen des Patentanspruchs 1 gelöst. Die Erfindung wird nachstehend anhand eines Ausführungsbeispieles näher erläutert.

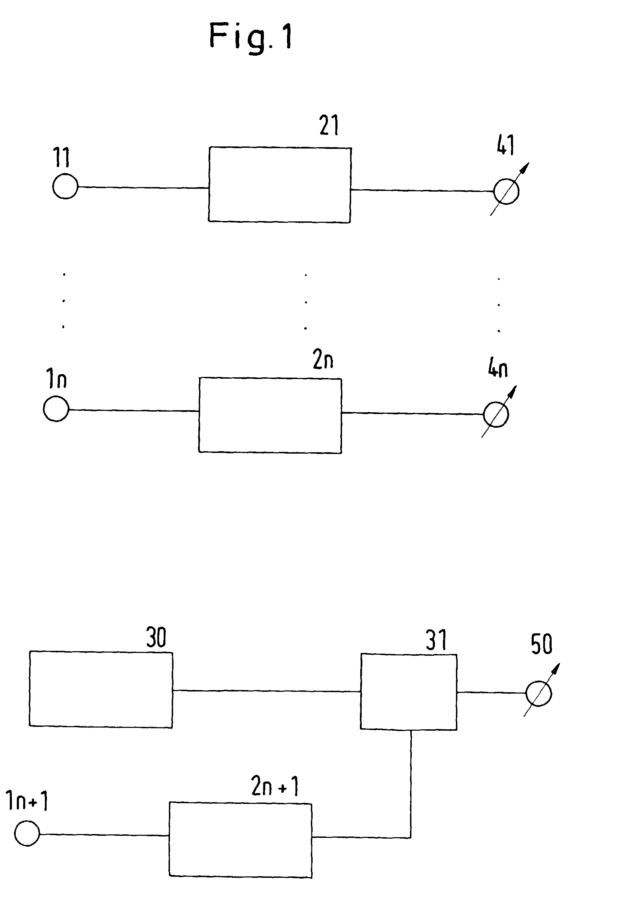

Dazu ist in Fig. 1 der prinzipielle Aufbau eines Linienschreibers dargestellt. Ausgehend von n Meßkanälen sind n Meßwerteingänge 11 bis 1n und n Meßwertbearbeitungsmittel 21 bis 2n vorgesehen, denen jeweils einer von n kontinuierlichen Schreibsystemen 41 bis 4n nachgeschaltet sind. Die Schreiborgane der kontinuierlichen Schreibsysteme 41 bis 4n befinden sich während des bestimmungsgemäßen Gebrauchs des Linienschreibers in ständigem Kontakt mit einem kontinuierlich oder schrittweise an den Schreiborganen vorbeibewegten Aufzeichnungsträger. Dabei wird der Aufzeichnungsträger senkrecht zur Bewegungsrichtung der Schreiborgane geführt.

Darüber hinaus ist ein diskontinuierliches Schreibsystem 50 vorgesehen, das über einen vorgeschalteten Multiplexer 31 wechselweise mit einem Zeichengenerator 30 oder einem weiteren Meßwertbearbeitungsmittel 2n+1 verbindbar ist. Dem weiteren Meßwertbearbeitungsmittel 2n+1 ist ein weiterer Meßwerteingang 1n+1 zugeordnet.

Während des bestimmungsgemäßen Gebrauchs des Linienschreibers sind dem diskontinuierlichen Schreibsystem 50 in Abhängigkeit vom Schaltzustand des Multiplexers 31 zwei verschiedene Betriebsmodi zuweisbar. Im ersten Betriebsmodus zur Aufzeichnung alphanumerischer Zeichen ist das diskontinuierliche Schreibsystem 50 mit einem Zeichengenerator 30 verbunden, und das Schreiborgan wird punktuell betätigt, d.h. mit dem Aufzeichnungsträger in Kontakt gebracht und wieder vom Aufzeichnungsträger abgehoben. Die aufzuzeichnenden alphanumerischen Zeichen werden rasterpunktweise im Rahmen einer vorgegebenen Punktmatrix schrittweise vervollständigt. Im zweiten Betriebsmodus zur Aufzeichnung von Meßwerten in Form eines graphischen Linienzuges ist das diskontinuierliche Schreibsystem 50 mit dem weiteren Meßwertbearbeitungsmittel 2n+1 verbunden. Während der Zeit geltenden zweiten Betriebsmodus befindet sich das Schreiborgan des diskontinuierlichen Schreibsystems 50 in ständigem Kontakt mit dem Aufzeichnungsträger.

Vorteilhafterweise sind auf diese Weise mit einem einzigen Schreibsystem 50 innerhalb eines Linienschreibers sowohl alphanumerische Zeichen als auch graphische Darstellung von Meßwertverläufen über die Zeit auf einen Aufzeichnungsträger aufzeichenbar.

In weiterer Ausbildung eines derartigen Linienschreibers ist vorgesehen, eingehende Meßwerte zu digitalisieren und die Mittel zur Meßwertbearbeitung 11 bis 1n+1 aller Meßkanäle sowie den Zeichengenerator 30 und den Multiplexer 31 in einer zentralen Verarbeitungseinheit mit einem Mikrorechner zu vereinen. In einem derartig ausgebildeten Linienschreiber weist jedes der Schreibsysteme 41 bis 50 einen digital ansprechbaren Schrittmotor auf, mit dem das zugeordnete Schreiborgan über die Breite des Aufzeichnungsträgers bewegbar ist.

### Bezugszeichenliste

- 11 bis 1n, 1n+1: Meßwerteingänge
- 21 bis 2n, 2n+1: Meßwertbearbeitungsmittel
- 30: Zeichengenerator
- 31: Multiplexer
- 41 bis 4n: kontinuierliche Schreibsysteme
- 50: diskontiuierliches Schreibsystem

## Patentansprüche

1. Linienschreiber mit n kontinuierlichen Schreibsystemen (41...4n), denen jeweils eine Meßwertbearbeitungsvorrichtung (21 ... 2n), zugeordnet ist, zur Aufzeichnung geschlossener Linienzüge und mindestens einem diskontinuierlichen Schreibsystem (50) zur Aufzeichnung von analogen Meßwerten und alphanumerischer Zeichen auf einem Aufzeichnungsträger umfassend einen Zeichengenerator (30) und eine Meßwertbearbeitungssvorrichtung (2n + 1) die wechselweise über einen Multiplexer (31) an das diskontinuierliche Schreibsystem (50) anschließbar sind,
**dadurch gekennzeichnet,**
daß dem diskontinuierlichen Schreibsystem (50) in Abhängigkeit von dem Schaltzustand des Multiplexers (31) zwei verschiedene Betriebsmodi zuweisbar sind, wobei das diskontinuierliche Schreibsystem (50) im ersten Betriebsmodus zur Aufzeichnung alphanumerischer Zeichen punktuell betätigbar ist, indem es mit dem Aufzeichnungsträger in Kontakt gebracht und wieder abgehoben wird, und im zweiten Betriebsmodus zur Aufzeichnung von analogen Meßwerten in ständigem Kontakt mit dem Aufzeichnungsträger steht, wobei die alphanumerischen Zeichen im ersten Betriebsmodus rasterpunktweise im Rahmen einer vorgegebenen Punktmatrix schrittweise vervollständigbar sind.

## Claims

1. A line recorder including n continuous write systems (41 ... 4n) each of which has an associated test value processing device (21 ... 2n) for recording closed line-trains and at least one discontinuous write system (50) for recording analogue test values and alphanumeric symbols on a recording medium, and comprising a symbol generator (30) and a test value processing device (2n + 1) which are alternately connectible to the discontinuous write system (50) via a multiplexer (31),
characterised in that
two different operational modes are attributable to the discontinuous write system (50) in dependence on the switched state of the multiplexer (31), whereby the discontinuous write system (50) is operable in the first operational mode for recording alphanumeric symbols in dot-by-dot manner by placing it in contact with the recording medium and then lifting it up again, and is in constant contact with the recording medium in the second operational mode for recording analogue test values, whereby the alphanumeric symbols are completable in step-by-step manner in the first operational mode using a dot pattern type process within the framework of a predefined dot matrix.

## Revendications

1. Enregistreur à tracé continu, comportant n systèmes d'écriture continus (41... 4n), auxquels, à chaque fois, il est associé un dispositif de traitement de valeurs de mesure (21... 2n), pour l'enregistrement de contours fermés et au moins un système d'écriture discontinu (50) pour l'enregistrement de valeurs de mesure analogiques et de caractères alphanumériques sur un support d'enregistrement, comportant un générateur de caractères (30) et un dispositif de traitement de valeurs de mesure (2n + 1) qui peuvent être raccordés, alternativement, par l'intermédiaire d'un multiplexeur (31), au système d'écriture discontinu (50),
caractérisé en ce qu'au système d'écriture discontinu (50), de façon dépendant de l'état de commutation du multiplexeur (31), deux différents modes de fonctionnement peuvent être affectés, le système d'écriture discontinu (50) pouvant être actionné de façon ponctuelle, dans le premier mode de fonctionnement, pour l'enregistrement de caractères alphanumériques, en ce qu'il est amené en contact avec le support d'enregistrement et en est à nouveau soulevé, et, dans le second mode de fonctionnement pour l'enregistrement de valeurs de mesure analogiques, étant en contact constant avec le support d'enregistrement, les caractères alphanumériques dans le premier mode de fonctionnement pouvant être complétés, à la manière de points de trame, pas à pas, dans le cadre d'une matrice ponctuelle prédéfinie.
